# EUROPEAN PATENT APPLICATION

(11) **EP 4 722 316 A1**
(43) Date of publication of application: **08.04.2026**
(21) Application number: 24836398.8
(22) Date of filing: 17.04.2024
(51) Int. Cl.: C09G 1/02, C09K 3/14, H01L 21/306, H01L 21/67, H01L 21/768, B24B 1/00, B24B 37/24, B24B 37/04

(54) **POLISHING COMPOSITION FOR SEMICONDUCTOR PROCESS AND SUBSTRATE POLISHING METHOD USING SAME**

(30) Priority: 06.07.2023 KR 20230087769
(71) Applicant: SK enpulse Co., Ltd., Seongnam-si, Gyeonggi-do 13453 (KR)
(72) Inventor: HAN, Deoksu, Seoul 03142 (KR)
(74) Representative: BCKIP Part mbB
(86) International application number: PCT/KR2024/095753
(87) International publication number: WO 2025/009951

(57) **Abstract**

A polishing composition for a semiconductor process according to one embodiment of the present specification includes polishing particles and a nonionic surfactant. A contact angle of the polishing composition for a semiconductor process with respect to a silicon oxide film is 30° to 40°. When such a polishing composition for a semiconductor process is applied to a CMP process, a polished surface having improved flatness and reduced defect occurrence frequency may be provided, and convenience of a polishing process may be improved.

## Description

### [TECHNICAL FIELD]

### [Cross-Reference to Related Application]

The present application claims priority to Korean Patent Application No. 10-2023-0087769 filed on July 6, 2023, and the contents of the patent document are incorporated in their entirety into the present invention by reference.

The present disclosure relates to a polishing composition for a semiconductor process and a substrate polishing method using the same, and the like.

### [BACKGROUND ART]

As semiconductor devices are further miniaturized and have higher density, finer pattern formation technology is used, and accordingly, a surface structure of the semiconductor device becomes more complicated and a step difference of interlayer films also becomes larger. In manufacturing a semiconductor device, a chemical mechanical polishing (Chemical Mechanical Polishing; hereinafter referred to as "CMP") process is used as a planarization technology for removing a step difference in a specific film formed on a substrate.

In the CMP process, while slurry is provided to a polishing pad, a substrate is pressurized and rotated and a surface is polished. Depending on a step of the process, an object to be planarized is different, and at this time, there is also a difference in physical properties of the slurry applied.

For polishing after metal wiring is formed, it is necessary to maintain a sufficient polishing rate and polishing speed while minimizing dishing or erosion, and the like.

### [PRIOR ART DOCUMENT]

### [PATENT DOCUMENT]

(Patent Document 1) Korean patent publication No. 10-2017-0021320
(Patent Document 2) Japanese patent publication No. H11-060232

### [DETAILED DESCRIPTION OF THE INVENTION]

### [TECHNICAL PROBLEM]

An object of the present disclosure is to provide a polishing composition for a semiconductor process which, when applied to a CMP process, may implement a polished surface having improved flatness and reduced defect occurrence frequency, and may improve convenience of a polishing process.

### [SOLUTION TO PROBLEM]

A polishing composition for a semiconductor process according to one embodiment of the present specification includes polishing particles; and a nonionic surfactant;.

The polishing composition for a semiconductor process has a contact angle with respect to a silicon oxide film of 30° to 40°.

The polishing composition for a semiconductor process may have a dynamic surface tension at a bubble lifetime of 10 seconds of 70 mN/m or less.

The polishing composition for a semiconductor process may have a viscosity at 25°C of 0.7 cP to 1.5 cP.

The polishing composition for a semiconductor process may have a pH of 3.5 to 5.

The polishing composition for a semiconductor process may have a zeta potential of +10 mV to +50 mV.

The polishing composition for a semiconductor process may further include a defoamer.

The defoamer may include a water-soluble polymer.

The defoamer may include a polyglycerin-based compound.

A weight-average molecular weight of the defoamer may be 200 g/mol to 2,000 g/mol.

The nonionic surfactant may include a polymer-based surfactant.

A weight-average molecular weight of the polymer-based surfactant may be 150 g/mol to 3,000 g/mol.

The polishing particles may have a positively charged surface.

A method of manufacturing a substrate according to another embodiment of the present specification includes a process of polishing a substrate by applying the polishing composition for a semiconductor process as a slurry.

### [ADVANTAGEOUS EFFECTS]

The polishing composition for a semiconductor process of the present disclosure, when applied to a CMP process, may implement a polished surface having improved flatness and reduced defect occurrence frequency, and may improve convenience of a polishing process.

### [MODE FOR CARRYING OUT THE INVENTION]

Hereinafter, examples will be described in detail so that a person having ordinary knowledge in the technical field to which the present disclosure pertains may readily carry out the present disclosure. However, the present disclosure may be embodied in various different forms, and is not limited to the examples described herein.

Throughout the present specification, terms indicating a degree such as "about" and "substantially" are used in a meaning at or close to the stated value when a manufacturing and material tolerance inherent in the stated meaning is presented, and are used to prevent an unscrupulous infringer from unfairly using disclosed content in which accurate or absolute values are stated to help understanding of the present disclosure.

Throughout the present specification, the term "combinations thereof" included in a Markush-type expression means one or more mixtures or combinations selected from a group consisting of components described in the Markush-type expression, and means including one or more selected from the group consisting of the components.

Throughout the present specification, the description of "A and/or B" means "A, B, or A and B".

Throughout the present specification, terms such as "first", "second", or "A", "B" are used to distinguish the same terms from each other unless otherwise stated.

In the present specification, the meaning that B is positioned on A means that B is positioned on A in contact with A, or another layer is positioned therebetween and B is positioned on A, and it is not construed as being limited to B being positioned in contact with a surface of A. In the present specification, a singular expression is construed as including a singular or plural meaning interpreted in context unless otherwise stated.

Hereinafter, the present disclosure will be described in detail.

### Physical properties of polishing composition

The polishing composition for a semiconductor process according to the present disclosure includes polishing particles; and a nonionic surfactant;.

The polishing composition for a semiconductor process has a contact angle with respect to a silicon oxide film of 30° to 40°.

A polishing composition having a controlled contact angle with respect to a silicon oxide film has improved affinity with respect to a substrate surface including the silicon oxide film, and may be uniformly distributed over an entire substrate surface during a polishing process. Through this, the substrate surface may be polished to have a smoother surface. In addition, affinity of the polishing composition with respect to various particles such as polishing particles and organic matter is improved, and thus the number of particles adsorbed on the substrate surface may be effectively reduced.

The contact angle of the polishing composition with respect to the silicon oxide film is measured using a contact angle meter. Specifically, according to a sessile drop method, after dropping 0.4 mL of the polishing composition onto a silicon oxide film wafer, the contact angle of the polishing composition is measured using the contact angle meter. For example, the contact angle meter may apply a Phoenix-MT model manufactured by SEO.

The contact angle of the polishing composition with respect to the silicon oxide film may be 30° to 40°. The contact angle may be 38° or less. The contact angle may be 32° or more. When a polishing composition having such properties is applied to a CMP process, a more precisely polished substrate surface may be provided. In addition thereto, a defect occurrence frequency derived from particles adsorbed on a polished surface may be effectively reduced.

At a bubble lifetime of 10 seconds, a dynamic surface tension of the polishing composition for a semiconductor process may be 70 mN/m or less.

The polishing composition of the present disclosure may exhibit a relatively low dynamic surface tension within a relatively short bubble lifetime, that is, low surface energy. Such a polishing composition may exhibit stable affinity with respect to a substrate surface and organic particles even when frequent movement occurs due to relative motion between a substrate and a polishing pad. In addition, adjusting the dynamic surface tension of the polishing composition within a preset range in the present disclosure may contribute to improvement of dispersibility of polishing particles.

The dynamic surface tension of the polishing composition is measured using a bubble pressure tensiometer according to a maximum bubble pressure method. The maximum bubble pressure method is a method of inserting a polishing composition to be measured into a capillary, injecting gas into the capillary, measuring an internal pressure of bubbles formed at an end of the capillary, and calculating dynamic surface tension from the measured value. In the maximum bubble pressure method, a bubble lifetime means a time required from when a bubble begins to be formed at the end of the capillary until an internal pressure of the bubble reaches a maximum.

When measuring the dynamic surface tension, a time interval is applied as 1 second, and a sample volume is applied as 2 mL. For example, a bubble pressure tensiometer may apply a BPA-1P model manufactured by Sinterface Tech.

The dynamic surface tension of the polishing composition for a semiconductor process at a bubble lifetime of 10 seconds may be 70 mN/m or less. The dynamic surface tension may be 69 mN/m or less. The dynamic surface tension may be 30 mN/m or more. When a polishing composition having such characteristics is applied to a CMP process, a polished surface in which defect occurrence is effectively reduced may be provided.

The polishing composition for a semiconductor process may have a viscosity at 25°C of 0.7 cP to 1.5 cP.

In a CMP process, a polishing pad and a substrate perform rotational motion under a pressurized condition, and a strong external force may act on the polishing composition supplied onto the substrate. In a case of a polishing composition including a surfactant, when such a polishing process is continuously performed, excessive foam may be generated. The present disclosure may help lower a degree of foam generation to a predetermined level or allow generated foam to be rapidly eliminated by controlling viscosity of the polishing composition. In addition, controlling viscosity of the polishing composition contributes to allowing the polishing composition to have a stable polishing rate with respect to a polished surface for a relatively long time.

The viscosity of the polishing composition is measured using a viscometer.

The viscosity of the polishing composition for a semiconductor process at 25°C may be 0.7 cP to 1.5 cP. The viscosity may be 0.8 cP or more. The viscosity may be 0.9 cP or more. The viscosity may be 1.3 cP or less. The viscosity may be 1.1 cP or less. Controlling viscosity of the polishing composition within the above range may help prevent excessive foam generation during a polishing process while allowing the polishing composition to maintain a stable polishing rate with respect to a polished surface.

The polishing composition for a semiconductor process may have a pH of 3.5 to 5. The pH may be 3.8 or more. The pH may be 4.0 or more. The pH may be 4.8 or less. The pH may be 4.6 or less. The pH may be 4.4 or less. The pH may be 4.3 or less. In such a case, the polishing composition may exhibit excellent polishing characteristics with respect to a polished surface including a silicon oxide film, and may help polishing particles to be stably dispersed.

The pH of the polishing composition for a semiconductor process is measured using a pH meter.

The polishing composition for a semiconductor process may have a zeta potential of +10 mV to +50 mV. The zeta potential may be +15 mV or more. The zeta potential may be +20 mV or more. The zeta potential may be +45 mV or less.

The zeta potential of the polishing particles may be +10 mV to +50 mV. The zeta potential may be +15 mV or more. The zeta potential may be +20 mV or more. The zeta potential may be +45 mV or less.

In such a case, the polishing composition may exhibit stable dispersibility, and may exhibit excellent polishing characteristics with respect to a silicon oxide film exhibiting a surface negative charge.

### Composition of polishing composition

### Polishing particles

The polishing composition may include polishing particles.

The polishing particles may include metal oxide particles and/or silicon oxide particles. The polishing particles may include silica. The polishing particles may include colloidal silica.

The polishing particles may include colloidal silica in an amount of 70 wt% or more. The polishing particles may include colloidal silica in an amount of 80 wt% or more. The polishing particles may include colloidal silica in an amount of 90 wt% or more. The polishing particles may be colloidal silica.

The polishing particles may have a positively charged surface. The polishing particles may be surface-modified to have a positively charged surface. The polishing particles may be surface-modified with a compound having an amine group. The polishing particles may be surface-modified with an amino silane.

The amino silane may be, for example, any one selected from the group consisting of 3-aminopropyltriethoxysilane, bis[(3-triethoxysilyl)propyl]amine, 3-aminopropyltrimethoxysilane, bis[(3-trimethoxysilyl)propyl]amine, 3-aminopropylmethyldiethoxysilane, 3-aminopropylmethyldimethoxysilane, N-[3-(trimethoxysilyl)propyl]ethylenediamine, N-bis[3-(trimethoxysilyl)propyl]-1,2-ethylenediamine, N-[3-(triethoxysilyl)propyl]ethylenediamine, diethylenetriaminopropyltrimethoxysilane, diethylenetriaminopropylmethyldimethoxysilane, diethylaminomethyltriethoxysilane, diethylaminopropyltrimethoxysilane, diethylaminopropyltriethoxysilane, dimethylaminopropyltrimethoxysilane, N-[3-(trimethoxysilyl)propyl]butylamine, and combinations thereof.

The polishing composition for a semiconductor process may include the amino silane in an amount of 50 ppm (by weight) to 300 ppm (by weight). The polishing composition for a semiconductor process may include the amino silane in an amount of 70 ppm (by weight) or more. The polishing composition for a semiconductor process may include the amino silane in an amount of 100 ppm (by weight) or more. The polishing composition for a semiconductor process may include the amino silane in an amount of 120 ppm (by weight) or more. The polishing composition for a semiconductor process may include the amino silane in an amount of 250 ppm (by weight) or less. The polishing composition for a semiconductor process may include the amino silane in an amount of 220 ppm (by weight) or less. The polishing composition for a semiconductor process may include the amino silane in an amount of 200 ppm (by weight) or less. The polishing composition for a semiconductor process may include the amino silane in an amount of 180 ppm (by weight) or less. In such a case, the polishing composition may have a more excellent polishing rate with respect to a silicon oxide film, may polish a surface of a substrate to be polished more smoothly, and may exhibit improved dispersibility. At the same time, it is possible to effectively suppress generation of residues of a surface modifier and adsorption of the residues onto a polished surface.

The polishing composition for a semiconductor process may include polishing particles in an amount of 1 wt% to 10 wt%. The polishing composition for a semiconductor process may include polishing particles in an amount of 2 wt% or more. The polishing composition for a semiconductor process may include polishing particles in an amount of 8 wt% or less. The polishing composition for a semiconductor process may include polishing particles in an amount of 5 wt% or less. In such a case, the polishing composition may have an excellent polishing rate with respect to a polished surface while stably suppressing aggregation of polishing particles.

An average particle diameter of the polishing particles may be 20 nm or more. The average particle diameter may be 30 nm or more. The average particle diameter may be 40 nm or more. The average particle diameter may be 70 nm or less. The average particle diameter may be 60 nm or less. The average particle diameter may be 50 nm or less. In such a case, the polishing composition may exhibit an excellent polishing rate with respect to a polished surface while stably controlling a frequency of defect occurrence on the polished surface.

The average particle diameter refers to an average particle diameter of primary particles of the polishing particles.

### Surfactant

The polishing composition for a semiconductor process includes a nonionic surfactant. The nonionic surfactant may improve affinity of the polishing composition with respect to a silicon oxide film, such that the polishing composition may be uniformly distributed on a surface to be polished during a polishing process. In addition, the nonionic surfactant may be attached to a surface to be polished with an appropriate strength to effectively interfere with adsorption of polishing particles having a positively charged surface onto the surface to be polished, while being easily removed from a surface of a substrate after polishing is completed.

The nonionic surfactant may include a polymer-based surfactant. A weight-average molecular weight of the polymer-based surfactant may be 150 g/mol to 3,000 g/mol.

The present disclosure may apply, to the polishing composition, a polymer-based surfactant which is a nonionic surfactant having a controlled main chain length. Through this, it is possible to effectively prevent a polishing rate of the polishing composition with respect to a polished surface from being reduced due to the nonionic surfactant adsorbed on the polished surface.

The weight-average molecular weight of the polymer-based surfactant is measured through GPC (Gel Permeation Chromatography).

The nonionic surfactant may include the polymer-based surfactant in an amount of 70 wt% or more. The nonionic surfactant may include the polymer-based surfactant in an amount of 80 wt% or more. The nonionic surfactant may include the polymer-based surfactant in an amount of 90 wt% or more. The nonionic surfactant may include the polymer-based surfactant in an amount of 100 wt% or less. The nonionic surfactant may be the polymer-based surfactant.

The polymer-based surfactant may have a weight-average molecular weight of 150 g/mol to 3,000 g/mol. The weight-average molecular weight may be 300 g/mol or more. The weight-average molecular weight may be 500 g/mol or more. The weight-average molecular weight may be 2,500 g/mol or less. The weight-average molecular weight may be 2,000 g/mol or less. The weight-average molecular weight may be 1,500 g/mol or less. In such a case, wettability of the polishing composition with respect to a silicon oxide film may be effectively improved, while a polishing rate of the polishing composition with respect to the silicon oxide film may be stably controlled, and defect occurrence derived from polishing particles within a polished surface may be effectively suppressed.

The nonionic surfactant may be a fluorine-based surfactant. The nonionic surfactant may be a fluoroalkyl alkylene oxide-based compound. The nonionic surfactant may be a compound according to Chemical Formula 1 below.

[Chemical Formula 1] R_{f}-(Rₑₙ-O)ₙ-H

In Chemical Formula 1, R_{f} is a fluoroalkyl group having 3 to 10 carbon atoms, Rₑₙ is an alkylene group having 2 or 3 carbon atoms, and n is an integer of 2 to 15.

In Chemical Formula 1, R_{f} may be a perfluoroalkyl group having 3 to 10 carbon atoms.

The nonionic surfactant may be, for example, triethylene glycol perfluoropentyl ether, triethylene glycol perfluorohexyl ether, triethylene glycol perfluoroheptyl ether, tetraethylene glycol perfluoropentyl ether, tetraethylene glycol perfluorohexyl ether, tetraethylene glycol perfluoroheptyl ether, pentaethylene glycol perfluoropentyl ether, pentaethylene glycol perfluorohexyl ether, pentaethylene glycol perfluoroheptyl ether, hexaethylene glycol perfluoropentyl ether, hexaethylene glycol perfluorohexyl ether, hexaethylene glycol perfluoroheptyl ether, and the like.

The polishing composition for a semiconductor process may include the nonionic surfactant in an amount of 10 ppm or more. The polishing composition for a semiconductor process may include the nonionic surfactant in an amount of 20 ppm or more. The polishing composition for a semiconductor process may include the nonionic surfactant in an amount of 50 ppm or more. The polishing composition for a semiconductor process may include the nonionic surfactant in an amount of 100 ppm or more. The polishing composition for a semiconductor process may include the nonionic surfactant in an amount of 150 ppm or more. The polishing composition for a semiconductor process may include the nonionic surfactant in an amount of 500 ppm or less. The polishing composition for a semiconductor process may include the nonionic surfactant in an amount of 450 ppm or less. In such a case, affinity of the polishing composition with respect to a polished surface may be effectively improved while suppressing excessive foam generation during a polishing process.

### Defoamer

The polishing composition for a semiconductor process further includes a defoamer. The defoamer is a material distinguished from the nonionic surfactant.

By applying both the nonionic surfactant and the defoamer to the polishing composition, the present disclosure may provide a polishing composition which has improved wettability with respect to a silicon oxide film while effectively suppressing bubble generation during a polishing process. In addition, the defoamer may help improve affinity of the polishing composition with respect to the silicon oxide film. The defoamer may include a water-soluble polymer. The water-soluble polymer may be uniformly distributed in the polishing composition without excessively increasing viscosity of the composition, thereby effectively suppressing bubble generation in the polishing composition.

The defoamer may include a polyglycerin-based compound.

The polyglycerin-based compound means polyglycer in and derivatives thereof. The polyglycerin-based compound may be, for example, polyglycerin-3, polyglycerin-4, polyglycerin-5, polyglycerin-10, polyglycerin-20, and the like.

A weight-average molecular weight of the defoamer may be 200 g/mol to 2,000 g/mol. The weight-average molecular weight may be 500 g/mol or more. The weight-average molecular weight may be 1,500 g/mol or less. The weight-average molecular weight may be 1,200 g/mol or less. In such a case, bubble formation that may occur during a polishing process may be effectively suppressed while suppressing excessive increase in viscosity of the polishing composition.

The weight-average molecular weight of the defoamer is measured through GPC (Gel Permeation Chromatography).

The polishing composition for a semiconductor process may include the defoamer in an amount of 0.001 wt% or more. The polishing composition for a semiconductor process may include the defoamer in an amount of 0.003 wt% or more. The polishing composition for a semiconductor process may include the defoamer in an amount of 0.005 wt% or more. The polishing composition for a semiconductor process may include the defoamer in an amount of 0.1 wt% or less. The polishing composition for a semiconductor process may include the defoamer in an amount of 0.08 wt% or less. The polishing composition for a semiconductor process may include the defoamer in an amount of 0.05 wt% or less. The polishing composition for a semiconductor process may include the defoamer in an amount of 0.03 wt% or less. In such a case, bubble generation of the polishing composition during a polishing process may be suppressed, thereby effectively improving convenience of the polishing process.

### Other additives

The polishing composition for a semiconductor process may further include other additives. The additives are not limited as long as they are commonly applied in the CMP field. For example, the additives may be at least one selected from a chelating agent, an oxidizing agent, an acid component, a pH adjusting agent, a dispersant, a polishing rate enhancer, a polishing controller, a polishing pad protector, and a preservative.

The polishing composition for a semiconductor process may further include a chelating agent. A metal or a metal ion removed from a substrate surface through a polishing process has a high possibility of being reattached to the substrate surface or remaining to form defects. In particular, a metal such as tungsten may be easily dissolved in the polishing composition under specific conditions, but may have characteristics of being easily attached to a surface to be polished. The chelating agent may be adsorbed onto such a metal or metal ion to easily remove the metal or the like. Through this, a polishing rate of the polishing composition may be further increased, and defect formation on a substrate surface due to particle reattachment may be effectively suppressed.

For example, the chelating agent may be at least one selected from the group consisting of butyric acid, citric acid, tartaric acid, succinic acid, oxalic acid, acetic acid, adipic acid, capric acid, caproic acid, caprylic acid, carboxylic acid, glutaric acid, glutamic acid, glycolic acid, thioglycolic acid, formic acid, mandelic acid, fumaric acid, lactic acid, lauric acid, malic acid, maleic acid, malonic acid, myristic acid, palmitic acid, phthalic acid, isophthalic acid, terephthalic acid, citraconic acid, propionic acid, pyruvic acid, stearic acid, valeric acid, benzoic acid, phenylacetic acid, naphthoic acid, aspartic acid, amino acids, and ethylenediaminetetraacetic acid.

As the amino acid, glycine, α-alanine, β-alanine, L-aspartic acid, N-methylglycine (methylglycine), and combinations thereof may be applied.

The chelating agent may include two or more carboxyl groups or alcohol groups in a molecule. Two or more kinds of chelating agents including two or more carboxyl groups or alcohol groups in a molecule may be applied. Specifically, the chelating agent may include any one selected from the group consisting of EDTA (ethylenediaminetetraacetic acid), glycine, carboxylic acids, and combinations thereof. The carboxylic acids mean compounds including at least one or two or more carboxyl groups in a molecule.

The polishing composition for a semiconductor process may include the chelating agent in an amount of 0.003 wt% to 0.5 wt%. The polishing composition for a semiconductor process may include the chelating agent in an amount of 0.005 wt% or more. The polishing composition for a semiconductor process may include the chelating agent in an amount of 0.3 wt% or less. In such a case, a polishing rate of the polishing composition may be controlled at an appropriate level, and a frequency of occurrence of surface defects of the substrate may be reduced.

The polishing composition for a semiconductor process may further include an oxidizing agent. The oxidizing agent oxidizes a metal such as tungsten to create an environment in which a substrate surface may be more easily planarized, and serves to improve a polishing rate and an etching rate.

The oxidizing agent may be at least one selected from the group consisting of hydrogen peroxide, urea hydrogen peroxide, urea, percarbonate, periodic acid, periodate, perchloric acid, perchlorate, perbromic acid, perbromate, perboric acid, perborate, permanganic acid, permanganate, persulfate, bromate, chlorate, hypochlorite, chromate, iodate, iodic acid, ammonium persulfate, benzoyl peroxide, calcium peroxide, barium peroxide, sodium peroxide, and peroxyurea.

The polishing composition for a semiconductor process may include the oxidizing agent in an amount of 0.01 wt% to 5 wt%. In such a case, the composition may exhibit excellent polishing characteristics with respect to a metal, and may suppress formation of an oxide film on a metal to be polished during a polishing process.

The polishing composition for a semiconductor process may further include a copper corrosion inhibitor. The copper corrosion inhibitor may include an azole-based compound.

The azole-based compound may be, for example, benzotriazole (BTA), 5-methyl-1H-benzotriazole (5-MBTA), 3-amino-1,2,4-triazole, 5-phenyl-1H-tetrazole, 3-amino-5-methyl-4H-1,2,4-triazole, 5-aminotetrazole (ATZ), 1,2,4-triazole, tolyltriazole, and combinations thereof.

The azole-based compound may include any one selected from the group consisting of 5-aminotetrazole (ATZ), 5-methyl-1H-benzotriazole (5-MBTA), and combinations thereof.

The azole-based compound may act on a copper surface during a polishing process to prevent corrosion of copper.

The azole-based compound may be included in an amount of 0.02 to 2.00 parts by weight based on 100 parts by weight of the polishing particles, may be included in an amount of 0.03 to 1.5 parts by weight, or may be included in an amount of 0.5 to 1.5 parts by weight.

When the azole-based compound is included within the above range, a corrosion inhibition effect on a copper surface of the polishing composition for a semiconductor process may be obtained, and in particular, a strong corrosion inhibition effect may be provided on a relatively large surface such as a via hole surface.

The polishing composition for a semiconductor process may further include an acid component. The acid component may be, for example, at least one selected from the group consisting of hydrochloric acid, phosphoric acid, sulfuric acid, hydrofluoric acid, bromic acid, iodic acid, formic acid, malonic acid, maleic acid, oxalic acid, acetic acid, adipic acid, citric acid, adipic acid, acetic acid, propionic acid, fumaric acid, lactic acid, salicylic acid, pimelic acid, benzoic acid, succinic acid, phthalic acid, butyric acid, glutaric acid, glutamic acid, glycolic acid, lactic acid, aspartic acid, tartaric acid, and salts thereof.

The polishing composition for a semiconductor process may further include a pH adjusting agent together with the acid component. The pH adjusting agent may be, for example, any one selected from the group consisting of ammonia, aminomethylpropanol, tetramethylammonium hydroxide, potassium hydroxide, sodium hydroxide, magnesium hydroxide, rubidium hydroxide, cesium hydroxide, sodium bicarbonate, sodium carbonate, imidazole, and combinations thereof.

The polishing composition for a semiconductor process may further include a dispersant.

The dispersant may prevent aggregation between polishing particles in the polishing composition and may uniformly disperse the polishing particles. A cationic dispersant may increase a zeta potential of the polishing composition to a positive value, and an anionic dispersant may decrease a zeta potential of the polishing composition to a negative value.

The dispersant may include an anionic low-molecular compound, a cationic polymer, an organic acid, and the like.

The anionic low-molecular compound of the dispersant may be one or more selected from oxalic acid, citric acid, polysulfonic acid, polyacrylic acid, polymethacrylic acid, and combinations thereof.

The cationic polymer of the dispersant may be one or more selected from polylysine, polyethyleneimine, benzethonium chloride, bronidox, cetrimonium bromide, cetrimonium chloride, dimethyldioctadecylammonium chloride, tetramethylammonium hydroxide, distearyldimethylammonium chloride, polyarylamine, and combinations thereof.

The organic acid of the dispersant may be one or more selected from hydroxybenzoic acid, ascorbic acid, picolinic acid, glutamic acid, tryptophan, aminobutyric acid, and combinations thereof.

A polishing rate enhancer is an additive for increasing a polishing rate of a substrate or wiring to be polished, and may be one or more selected from potassium nitrate, iron nitrate, ammonium hydroxide, citric acid, acetic acid, and combinations thereof.

A polishing controller is for minimizing adsorption of the polishing composition onto a metal surface, and may include ammonium compounds, potassium nitrate, amino acids, salts thereof, and the like.

The polishing composition for a semiconductor process may include a solvent. The solvent may be water, and specifically may be ultrapure water.

### Polishing characteristics of polishing composition

A polishing rate of the polishing composition for a semiconductor process with respect to a silicon oxide film may be 1000 Å/min or more. The polishing rate may be 1100 Å/min or more. The polishing rate may be 1200 Å/min or more. The polishing rate may be 3000 Å/min or less. The polishing rate may be 2500 Å/min or less. The polishing rate may be 2000 Å/min or less.

A polishing rate of the polishing composition for a semiconductor process with respect to a tungsten film may be 50 Å/min or more. The polishing rate may be 70 Å/min or more. The polishing rate may be 500 Å/min or less. The polishing rate may be 300 Å/min or less. The polishing rate may be 200 Å/min or less.

In such a case, the polishing composition may exhibit an excellent polishing rate selectivity of the silicon oxide film relative to the polishing rate of the tungsten film.

An Ra value of a tungsten film measured after polishing for 30 seconds using the polishing composition for a semiconductor process may be 3 nm or less. The Ra value may be 2 nm or less. In such a case, the polishing composition may provide a polished surface having a smoother surface.

The Ra value is measured based on ISO 4287.

Polishing for each thin film is performed under conditions of a pressure of 2.2 psi, a carrier speed of 87 rpm, a platen speed of 93 rpm, and a slurry flow rate of 250 mL/min. A polishing pad may apply an SR-300 model manufactured by SK Enpulse.

When measuring a polishing rate for each thin film, a polishing apparatus may apply, for example, an AP-300 model manufactured by CTS.

### Method of manufacturing a substrate

A method of manufacturing a substrate of the present disclosure includes a process of polishing a substrate by applying the polishing composition for a semiconductor process as a slurry.

The substrate may include at least one of an insulating film, metal wiring, or a barrier layer on an upper surface thereof. The metal wiring may include copper or tungsten. When the metal wiring includes copper, the barrier layer may include tantalum and a nitride thereof. When the metal wiring includes tungsten, the barrier layer may include titanium and a nitride thereof.

Specifically, the process of polishing the substrate may be performed by bringing a substrate to be polished into contact with a polishing pad together with the polishing composition for a semiconductor process supplied from a spray nozzle, while a polishing head fixing the substrate rotates and a platen to which the polishing pad is attached also rotates.

The process of polishing the substrate may further include, as necessary, a process of conditioning a surface of the polishing pad before polishing.

The polishing composition for a semiconductor process may polish a wafer that is in contact with the polishing pad while penetrating toward the substrate.

In the process of polishing the substrate, a pressure of 6.89 kPa to 48.26 kPa may be applied. The pressure may be 13.79 kPa to 34.47 kPa.

The process of polishing the substrate may be performed for 50 seconds to 10 minutes. However, the process may be changed depending on a degree of polishing to be achieved.

Description of the polishing composition for a semiconductor process is omitted since it overlaps with the above description.

The method of manufacturing a substrate may further include a cleaning process of cleaning the polished substrate.

The cleaning process may be performed by cleaning the polished substrate with purified water and an inert gas.

Hereinafter, specific examples will be described in more detail. The following examples are merely examples for helping understanding of the present disclosure, and the scope of the present disclosure is not limited thereto.

### Preparation Example: Preparation of polishing composition

Example 1: A polishing composition having a total amount of 100 wt% was prepared by introducing and mixing, into ultrapure water as a solvent, 2 wt% of silica having an average diameter (based on primary particles) of 45 nm surface-modified with (3-aminopropyl)triethoxysilane at 150 ppm (by weight) as polishing particles, 100 ppm (by weight) of FS 3100 manufactured by Capstone as a nonionic surfactant, and nitric acid as a pH adjusting agent. A pH of the polishing composition was adjusted to 3.8.

Example 2: A polishing composition having a total amount of 100 wt% was prepared under the same conditions as in Example 1 except that 0.01 wt% of polyglycerin having a weight-average molecular weight of 750 g/mol was further included (ultrapure water was excluded by a corresponding amount).

Example 3: A polishing composition having a total amount of 100 wt% was prepared under the same conditions as in Example 1 except that 30 ppm of the nonionic surfactant was applied.

Comparative Example 1: A polishing composition having a total amount of 100 wt% was prepared under the same conditions as in Example 1 except that the nonionic surfactant was not applied.

Comparative Example 2: A polishing composition having a total amount of 100 wt% was prepared under the same conditions as in Example 1 except that 1000 ppm of the nonionic surfactant was applied.

Comparative Example 3: A polishing composition having a total amount of 100 wt% was prepared by introducing and mixing, into ultrapure water as a solvent, 2 wt% of silica having an average diameter (based on primary particles) of 45 nm which was not surface-modified as polishing particles, and nitric acid as a pH adjusting agent. A pH of the polishing composition was adjusted to 3.8.

Contents of components in the polishing compositions of Examples and Comparative Examples, zeta potential, and viscosity of the polishing compositions were applied as shown in Table 1 below.

### Evaluation Example: Measurement of contact angle of polishing composition with respect to silicon oxide film

A contact angle of the polishing compositions of Examples and Comparative Examples with respect to a silicon oxide film was measured using a Phoenix-MT contact angle meter manufactured by SEO. Specifically, according to a sessile drop method, after dropping 0.4 mL of the polishing compositions of Examples and Comparative Examples onto a silicon oxide film wafer, a contact angle of the polishing composition was measured using the contact angle meter.

Measured values for Examples and Comparative Examples are shown in Table 2 below.

### Evaluation Example: Measurement of dynamic surface tension of polishing composition

Dynamic surface tension of the polishing compositions of Example 3 and Comparative Example 1 was measured using a BPA-1P bubble pressure tensiometer manufactured by Sinterface Tech according to a maximum bubble pressure method. When measuring dynamic surface tension, a time interval was applied as 1 second and a sample volume was applied as 2 mL. The measured dynamic surface tension was measured as a value at a bubble lifetime of 10 seconds.

Measured values for Examples and Comparative Examples are shown in Table 2 below.

### Evaluation Example: Measurement of polishing rate for each thin film

Polishing rates with respect to a silicon oxide film and a tungsten film formed on a wafer having a diameter of 300 mm were measured by applying the polishing compositions of Examples 1 to 3 and Comparative Examples 1 and 2 as a slurry. Polishing rates for each thin film were measured under conditions of a polishing time of 60 seconds, a pressure of 2.2 psi, a carrier speed of 93 rpm, a platen speed of 87 rpm, and a slurry flow rate of 300 mL/min, and a polishing apparatus applied was an AP-300 model manufactured by CTS.

Measured polishing rates for each thin film of Examples and Comparative Examples are shown in Table 3 below.

### Evaluation Example: Measurement of roughness of polished surface

A tungsten film formed on a wafer having a diameter of 300 mm and an arithmetic average roughness (Ra) value of 10.33 nm according to ISO 4287 was polished by applying the polishing compositions of Example 1 and Comparative Example 3 as a slurry. The tungsten film was polished under the same conditions as those applied in the polishing rate measurement evaluation example described above, except that a polishing time of 30 seconds was applied.

Thereafter, an arithmetic average roughness (Ra) according to ISO 4287 of a surface of the tungsten film polished using the polishing compositions of Examples and Comparative Examples was measured using an atomic force microscope, namely, a Park XE-100 model manufactured by Park Systems.

Measured values for Examples and Comparative Examples are shown in Table 3 below.

### Evaluation Example: Measurement of defect density of polished surface

A silicon oxide film formed on a wafer having a diameter of 300 mm was polished by applying the polishing compositions of Examples 1 and 3 and Comparative Examples 1 and 2 as a slurry. The silicon oxide film was polished under the same conditions as those applied in the polishing rate measurement evaluation example described above.

The number of defects formed on a surface of the SiO₂ wafer after polishing was measured using a wafer defect inspection apparatus, namely, an AIT-XP+ model manufactured by KLA Tencor.

Measured results for Examples and Comparative Examples are shown in Table 3 below.

### Evaluation Example: Measurement of foam generation degree

After introducing the polishing compositions of Examples 1 to 3 and Comparative Examples 1 and 2 into a cylindrical container having a diameter of 150 mm, a propeller having a blade diameter of 100 mm was disposed in the polishing composition. The polishing composition was stirred for 1 minute by applying a propeller rotation speed of 100 rpm. A height of foam generated from the polishing composition after completion of stirring was measured.

Measured results for Examples and Comparative Examples are shown in Table 3 below.

**[Table 1]**

| | Polishing particle content (wt%) | Surface modifier content (ppm) | Surfactant content (ppm) | Polyglycerin content (wt%) | Zeta potential (mV) | Viscosity (cP) |
|---|---|---|---|---|---|---|
| Example 1 | 2 | 150 | 100 | 0 | 28 | 1.02 |
| Example 2 | 2 | 150 | 100 | 0.01 | 28 | 1.02 |
| Example 3 | 2 | 150 | 30 | 0 | 28 | 1.02 |
| Comparative Example 1 | 2 | 150 | 0 | 0 | 28 | 1.02 |
| Comparative Example 2 | 2 | 150 | 1000 | 0 | 28 | 1.02 |
| Comparative Example 3 | 2 | 0 | 0 | 0 | -23 | 1.02 |

**[Table 2]**

| | Contact angle (°) | Dynamic surface tension (mN/m) |
|---|---|---|
| Example 1 | 37 | - |
| Example 2 | 37 | - |
| Example 3 | 36 | 68.9 |
| Comparative Example 1 | 64 | 70.6 |
| Comparative Example 2 | 35 | - |
| Comparative Example 3 | 64 | - |

**[Table 3]**

| | Polishing rate for silicon oxide film (A/min) | Polishing rate for tungsten film (A/min) | Ra value of polished surface (nm) | Defect density of polished surface (counts/wafer) | Foam height (mm) |
|---|---|---|---|---|---|
| Example 1 | 1280 | 100 | 1.98 | 64 | 40 |
| Example 2 | 1280 | 100 | - | - | 35 |
| Example 3 | 1280 | 110 | - | 35 | 30 |
| Comparative Example 1 | 1280 | 100 | - | 892 | 0 |
| Comparative Example 2 | 1180 | 160 | - | 41 | 1000 |
| Comparative Example 3 | - | - | 4.94 | - | - |

With respect to the Ra value of the polished surface in Table 3, in the case of Example 1, the Ra value was measured to be 2 nm or less, whereas in the case of Comparative Example 3, the Ra value was measured to exceed 4.5 nm. This indicates that polishing particles subjected to surface modification may implement a smoother polished surface.

With respect to defect density of the polished surface, in the cases of Examples 1 and 3 and Comparative Example 2, defects per wafer were measured to be 100 or less, whereas in the case of Comparative Example 1, defects per wafer were measured to exceed 850. This is considered to be because the polishing composition having a controlled contact angle with respect to the silicon oxide film may be uniformly distributed within the polished surface during a polishing process, and the surfactant interferes with adsorption of polishing particles onto the polished surface.

With respect to foam height, Example 2 exhibited a smaller amount of foam than Example 1. This is considered to be because the polyglycerin included in the polishing composition of Example 2 effectively suppressed foam generation during a stirring process.

Hereinabove, preferred examples have been described in detail, but the scope of the present disclosure is not limited thereto, and various modifications and improvements by a person having ordinary skill in the art using the basic concept of the present disclosure as defined in the following claims are also included in the scope of the present disclosure.

## Claims

1. A polishing composition for a semiconductor process, comprising:
polishing particles; and a nonionic surfactant;
wherein a contact angle with respect to a silicon oxide film is 30° to 40°.

2. The polishing composition for a semiconductor process of claim 1,
wherein a dynamic surface tension at a bubble lifetime of 10 seconds is 70 mN/m or less.

3. The polishing composition for a semiconductor process of claim 1,
wherein a viscosity at 25 °C is 0.7 cP to 1.5 cP.

4. The polishing composition for a semiconductor process of claim 1,
wherein a pH is 3.5 to 5.

5. The polishing composition for a semiconductor process of claim 1,
wherein a zeta potential is +10 mV to +50 mV.

6. The polishing composition for a semiconductor process of claim 1,
further comprising a defoamer,
wherein the defoamer comprises a water-soluble polymer.

7. The polishing composition for a semiconductor process of claim 6,
wherein the defoamer comprises a polyglycerin-based compound.

8. The polishing composition for a semiconductor process of claim 6,
wherein a weight-average molecular weight of the defoamer is 200 g/mol to 2,000 g/mol.

9. The polishing composition for a semiconductor process of claim 1,
wherein the nonionic surfactant comprises a polymer-based surfactant, and
wherein a weight-average molecular weight of the polymer-based surfactant is 150 g/mol to 3,000 g/mol.

10. The polishing composition for a semiconductor process of claim 1,
wherein the polishing particles have a positively charged surface.

11. A method of manufacturing a substrate, comprising:
polishing a substrate by applying the polishing composition for a semiconductor process of claim 1 as a slurry.
